# DEMANDE DE BREVET EUROPEEN

(11) **EP 1 598 675 A1**
(43) Date de publication de la demande: **23.11.2005**
(21) Numéro de dépôt: 05291008.0
(22) Date de dépôt: 11.05.2005
(51) Int. Cl.: G01R 31/36

(54) **Procédé permettant une gestion optimale de la charge d'une batterie d'un terminal de télécommunication mobile**

(30) Priorité: 19.05.2004 FR 0405497
(71) Demandeur: France Telecom S.A., 75015 Paris (FR)
(72) Inventeur: Losquin, Patrick, 23300 Lannion (FR); Descos, Jérôme, 22700 Louannec (FR)
(74) Mandataire: Maillet, Alain

(57) **Abrégé**

L'invention concerne un procédé de transmission de données au moyen d'au moins un terminal mobile, lequel procédé impliquant une surveillance d'un niveau de charge d'une batterie d'un terminal mobile et incluant:
- une étape de mesure d'une valeur courante d'un paramètre représentatif dudit niveau de charge ;
- une étape de comparaison de la valeur courante ainsi mesurée avec une valeur seuil prédéterminée ; et
- une étape de configuration du terminal en un mode de fonctionnement économique préalablement défini si la valeur courante est inférieure ou égale à la valeur seuil.

## Description

La présente invention concerne un procédé de transmission de données au moyen d'au moins un terminal mobile, lequel procédé impliquant une surveillance d'un niveau de charge d'une batterie d'un terminal mobile.

Des procédés destinés à prolonger la durée de vie des batteries de terminaux mobiles sont connus des documents décrits ci-après.

Dans le document intitulé « Réduction de consommation d'énergie en électronique embarquée » (ENSSAT - Université de Rennes LASTI - Groupe Signal Architecture), Olivier Sentieys constate que les appareils portables consomment de plus en plus vite la charge de leur batterie et que ce phénomène va s'amplifiant. Il propose donc de freiner cette consommation en faisant varier certains paramètres du terminal mobile et notamment en réduisant la tension d'alimentation, la capacité effective et la fréquence d'horloge.

Dans le document intitulé « Optimisation de la consommation d'énergie des applications de traitements du signal et de l'image embarquées sur DSP » (S. Pignolo, E. Martin, N. Julien, E. Senn, B. Saget - LESTER - Univ. Bretagne Sud), les auteurs constatent que les applications embarquées sur les terminaux mobiles se développent plus vite que les outils matériels associés et que ce décalage est source de problèmes de surchauffe des batteries et limite leur autonomie. Ils proposent donc d'exploiter différents états de différentes applications embarquées sur un terminal mobile pour par exemple gérer la consommation d'énergie de ce terminal à l'aide de modes « veille », ou encore d'adapter une tension d'alimentation et/ou une fréquence de fonctionnement d'un tel terminal en rapport avec une tâche logicielle à accomplir.

Les documents décrits précédemment présentent des méthodes pour réduire l'énergie consommée par différents composants du terminal ou pour optimiser leur consommation. Ces méthodes ne permettent qu'une gestion programmée de l'énergie consommée par le terminal mobile et ne permettent pas de tenir compte des besoins de l'utilisateur qui se retrouve rapidement dans l'impossibilité d'utiliser son terminal une fois dépassé un seuil critique d'utilisation.

Un but de l'invention est donc de proposer un procédé permettant de gérer la charge de la batterie d'un terminal mobile sous contrôle de l'utilisateur de ce terminal.

A cet effet, l'invention propose un procédé de transmission de données au moyen d'au moins un terminal mobile, lequel procédé impliquant une surveillance d'un niveau de charge d'une batterie d'un terminal mobile et incluant :
- une étape de mesure d'une valeur courante d'un paramètre représentatif dudit niveau de charge ;
- une étape de comparaison de la valeur courante ainsi mesurée avec une valeur seuil prédéterminée ; et
- une étape de configuration du terminal en un mode de fonctionnement économique préalablement défini si la valeur courante est inférieure ou égale à la valeur seuil.

Le procédé selon l'invention permet à l'utilisateur du terminal mobile d'être averti d'une faible autonomie restante de son terminal et ainsi de contrôler cette autonomie soit en utilisant rapidement la charge restante, soit en économisant l'énergie restante le plus longtemps possible.

Selon un premier mode de mise en oeuvre particulier de l'invention, le procédé inclut en outre une étape de chargement préalable de données de configuration définissant le mode de fonctionnement économique.

Selon un second mode de mise en oeuvre particulier de l'invention, le procédé inclut en outre une étape d'identification d'un mode de fonctionnement actif dans lequel se trouve le terminal, destinée à être exécutée préalablement à l'étape de configuration.

L'étape d'identification du mode de fonctionnement actif permet d'assurer à l'utilisateur un fonctionnement du terminal adapté au niveau de charge de la batterie du terminal.

Selon un troisième mode de mise en oeuvre particulier de l'invention, le procédé inclut en outre une étape d'alerte, au cours de laquelle au moins un stimulus d'alerte est émis à l'attention de l'utilisateur afin de l'informer d'un faible niveau de charge de la batterie et d'un possible changement de mode de fonctionnement, ladite étape d'alerte étant destinée à être exécutée préalablement à l'étape de configuration.

L'étape d'alerte de l'utilisateur permet d'avertir l'utilisateur d'un faible niveau de charge de la batterie de son terminal afin que cet utilisateur décide soit de rester dans le mode actif et de bénéficier de l'ensemble des fonctions et services de son terminal, soit de configurer son terminal en mode de fonctionnement économique et d'en augmenter ainsi l'autonomie, certaines fonctions et services n'étant plus alors accessibles.

Selon un quatrième mode de mise en oeuvre particulier de l'invention, le procédé inclut en outre une étape de vérification d'alerte destinée à apporter confirmation de l'émission effective d'au moins un stimulus d'alerte, ladite étape de vérification étant destinée à être exécutée préalablement à l'étape de configuration.

L'étape de vérification permet d'assurer que le mode de fonctionnement du terminal mobile aura véritablement été choisi, même tacitement par l'utilisateur.

L'invention concerne également un dispositif de transmission de données au moyen d'au moins un terminal mobile, lequel dispositif impliquant une surveillance d'un niveau de charge d'une batterie d'un terminal mobile et incluant :
- des moyens de mesure d'une valeur courante d'un paramètre représentatif dudit niveau de charge ;
- des moyens de comparaison de la valeur courante ainsi mesurée avec une valeur seuil prédéterminée ; et
- des moyens de configuration du terminal en un mode de fonctionnement économique préalablement défini si la valeur courante est inférieure ou égale à la valeur seuil.

Selon un premier mode de réalisation particulier de l'invention, le dispositif inclut en outre des moyens de chargement préalable de données de configuration définissant le mode de fonctionnement économique.

Selon un second mode de réalisation particulier de l'invention, le dispositif inclut en outre des moyens d'identification du mode de fonctionnement actif dans lequel se trouve le terminal, destinés à être activés préalablement à la mise en oeuvre des moyens de configuration.

Selon un troisième mode de réalisation particulier de l'invention, le dispositif inclut en outre des moyens d'alerte prévus pour émettre au moins un stimulus d'alerte à l'attention de l'utilisateur afin de l'informer d'un faible niveau de charge de la batterie et d'un possible changement de mode de fonctionnement, les moyens d'alerte étant destinés à être activés préalablement à la mise en oeuvre des moyens de configuration.

Selon un quatrième mode de réalisation particulier de l'invention, le dispositif inclut en outre des moyens de vérification d'alerte destinés à apporter confirmation de l'émission effective d'au moins un stimulus d'alerte, lesdits moyens de vérification étant destinés à être activés préalablement à la mise en oeuvre des moyens de configuration.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
- la Fig. 1 est un schéma synoptique qui représente un procédé selon l'invention, et
- la Fig. 2 est un schéma fonctionnel qui représente un terminal dans lequel l'invention est mise en oeuvre.

Le procédé selon l'invention est un procédé de transmission de données d'un niveau de charge d'une batterie d'un terminal mobile. Un tel terminal mobile pourra par exemple être constitué par un téléphone portable, un ordinateur portable, un assistant personnel, etc. Dans un mode de mise en oeuvre particulier de l'invention, le terminal mobile utilisé est un téléphone de type « Smartphone » mettant en oeuvre un système d'exploitation de type « Windows CE », les signes « Smartphone » et « Windows CE » étant connus de l'homme du métier et pouvant faire l'objet d'une protection en tant que marques de fabrique.

Le niveau de charge d'une batterie d'un terminal mobile est lié à l'autonomie que fournit cette batterie avant de devoir être rechargée. Ainsi, quand le niveau de charge d'une batterie est proche d'une valeur seuil considérée comme une valeur en-deçà de laquelle la batterie ne peut plus permettre au terminal de fonctionner correctement, le terminal peut se voir configurer en un mode de fonctionnement aussi économique que possible, dans lequel ledit terminal n'est plus alimenté en tension.

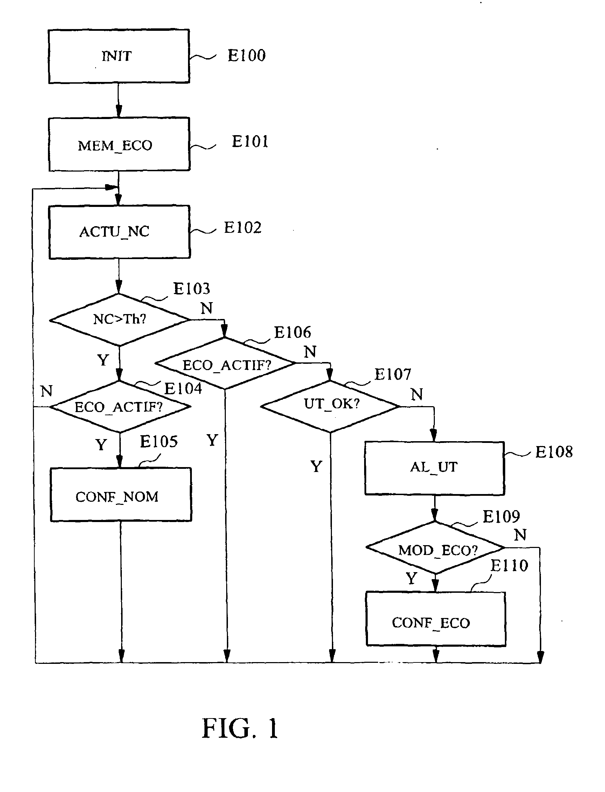

Dans le procédé selon l'invention illustré à la Fig. 1, le niveau de charge de la batterie du terminal est surveillé de la manière suivante : au cours d'une étape d'initialisation E100 correspondant à la mise sous tension du terminal mobile, celui-ci est configuré en un mode de fonctionnement dit initial, qui est par exemple celui dans lequel se trouvait le terminal lors d'une précédente mise hors tension du terminal.

Au cours d'une étape de mémorisation E101, le terminal mobile mémorise un profil définissant un mode de fonctionnement dit mode de fonctionnement économique. Ce mode de fonctionnement économique est un mode de fonctionnement paramétré pour que seules des fonctions considérées comme indispensables à l'utilisateur soient activées, toute autre fonction étant inhibée. Ainsi, si dans un mode de fonctionnement nominal, considéré comme le mode de fonctionnement habituel normal, des fonctions 1 à 5 et des services 1 à 5 sont actifs, un mode de fonctionnement économique pourra par exemple prévoir de n'activer que les fonctions 1, 2 et 4 et les services 2 et 5, les autres fonctions 3 et 5 et les autres services 1, 3 et 4 étant alors inhibés.

Deux modes de fonctionnement économique sont prévus dans ce mode particulier de mise en oeuvre de l'invention. Un premier mode de fonctionnement économique est le mode de fonctionnement par défaut. Dans ce mode de fonctionnement économique par défaut, les fonctions et services du terminal mobile sont paramétrés de manière à n'autoriser qu'un fonctionnement minimal du terminal. Ainsi, pour un téléphone portable, les fonctions et services seront réduits à l'émission et à la réception d'appels et de messages. Dans un mode de mise en oeuvre particulier de l'invention, les services et fonctions inactivés dans ce mode de fonctionnement par défaut sont par exemple la veille d'écran, le rétro-éclairage, la sonorisation du clavier, les options de sonnerie, le haut-parleur, le volume d'écoute, les jeux et services multimédias, etc.

Un second mode de fonctionnement est le mode de fonctionnement personnalisable. Dans ce mode de fonctionnement personnalisable, les fonctions et services actifs sont choisis par l'utilisateur. Par exemple, pour un téléphone portable, l'utilisateur peut choisir d'activer son répertoire en plus des fonctions et services d'appel, malgré que ce répertoire ne soit pas un service nécessaire à l'émission ou la réception d'appels ou de messages. L'utilisateur choisit ainsi le mode de fonctionnement qu'il souhaite voir utilisé par le terminal en tant que mode de fonctionnement économique.

Dans chacun des modes de fonctionnement économique possibles, les fonctions et services actifs sont par ailleurs configurés de manière à réduire au maximum leur consommation. En outre, il est prévu qu'en mode de fonctionnement économique, le terminal mobile affiche le temps d'utilisation restant avant la configuration hors-tension du terminal.

Dans un mode de mise en oeuvre particulier de l'invention, les fonctions et services du mode de fonctionnement économique par défaut et du mode de fonctionnement personnalisable sont listés dans un fichier de paramètres enregistré de manière permanente dans une base de registres du terminal mobile. L'état des fonctions et services de ce fichier peut être modifié aisément par l'intermédiaire de l'interface du terminal.

Au cours d'une étape de mesure E102, le terminal mobile actualise le niveau de charge de sa batterie en mesurant une valeur courante NC d'un paramètre représentatif du niveau de charge. L'actualisation du niveau de charge permet d'obtenir une appréciation de l'autonomie restante du terminal mobile.

La valeur courante du niveau de charge ainsi mesurée est comparée à une valeur seuil prédéterminée Th au cours d'une étape de comparaison E103. Cette valeur seuil se situe de préférence à un intervalle d'une valeur de seuil critique, laquelle valeur de seuil critique est approximativement nulle. La valeur seuil Th est choisie de manière à ce que la charge de la batterie correspondante puisse assurer un mode de fonctionnement économique pendant une durée déterminée.

S'il apparaît, à l'issue de l'étape de comparaison E103, que la valeur courante NC du niveau de charge est supérieure ou égale à la valeur seuil Th, l'étape suivante est une première étape d'identification E104. Sinon, l'étape suivante est une seconde étape d'identification E106.

Au cours de la première étape d'identification E104, le mode de fonctionnement actif est identifié. Si le mode de fonctionnement actif n'est pas le mode de fonctionnement économique, c'est-à-dire si par exemple le mode de fonctionnement est le mode de fonctionnement nominal, alors le procédé prévoit de revenir à l'étape de mesure E102 sans agir sur le mode de fonctionnement actif. En revanche, si le mode de fonctionnement actif est le mode de fonctionnement économique, la valeur courante NC de la charge de la batterie ne justifiant pas ce mode de fonctionnement inutilement restrictif, le terminal est configuré au cours d'une étape de configuration E105 en un mode de fonctionnement nominal. Le procédé prévoit ensuite de revenir à l'étape de mesure E102 sans agir sur le mode de fonctionnement actif.

Au cours de la seconde étape d'identification E106, le mode de fonctionnement actif est également identifié. Si le mode de fonctionnement actif est le mode de fonctionnement économique, alors le procédé prévoit de revenir à l'étape de mesure E102 sans effectuer aucune autre action. Sinon, au cours d'une étape de vérification E107, le procédé prévoit de vérifier si l'utilisateur a été alerté du faible niveau de charge de la batterie. Si l'utilisateur a déjà été alerté, le procédé prévoit de revenir à l'étape de mesure E102 sans autre action. Sinon, au cours d'une étape d'alerte E108, une alerte sous forme d'un stimulus d'alerte est transmise par le terminal mobile à l'utilisateur, afin de l'informer d'un faible niveau de charge de la batterie et d'un possible changement de mode de fonctionnement. Ce stimulus peut par exemple être un signal lumineux, un message, etc. Si l'utilisateur décide le passage au mode de fonctionnement économique, le mode de fonctionnement économique devient alors le mode de fonctionnement actif. Si l'utilisateur n'accepte pas le changement de mode de fonctionnement, le terminal est maintenu en mode de fonctionnement nominal. Le procédé prévoit ensuite, quel que soit le mode de fonctionnement choisi, de revenir à l'étape de mesure E102 de manière à maintenir l'utilisateur au fait de la valeur de la charge restante dans la batterie avant la mise hors-tension du terminal.

De manière générale, le procédé doit de préférence interférer aussi peu que possible avec le fonctionnement général du terminal.

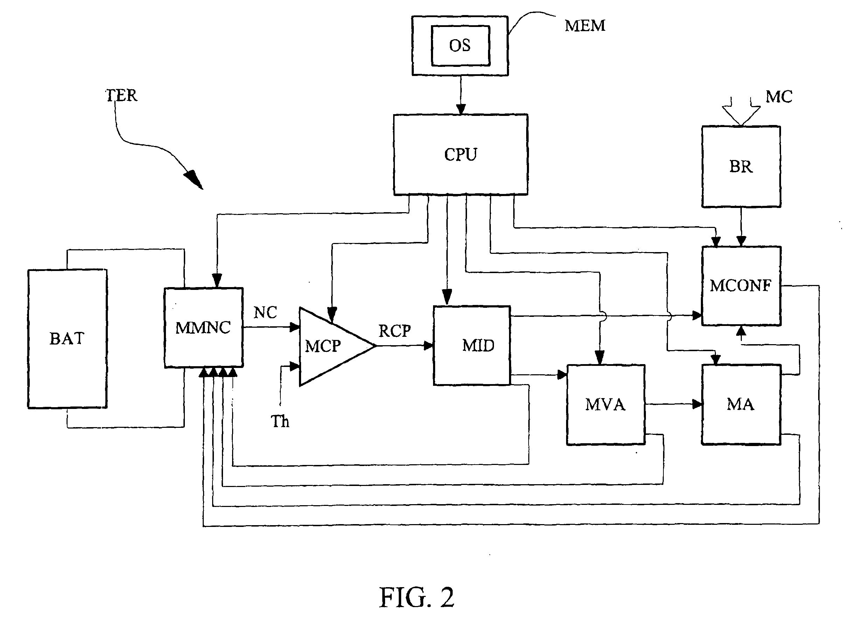

Le procédé selon l'invention est de préférence mis en oeuvre par un dispositif de transmission de données inclus dans un terminal TER tel qu'illustré à la Fig. 2. Dans ce mode de réalisation particulier de l'invention, le fonctionnement de ce dispositif de transmission de données est géré par un système d'exploitation OS qui contrôle une unité centrale CPU, lequel système d'exploitation OS est enregistré de façon permanente dans la mémoire MEM incluse ou au sein du terminal mobile TER. Sous le contrôle du système d'exploitation OS, l'unité centrale CPU est destinée à piloter des activations et des désactivations de moyens de mesure MMNC, des moyens de comparaison MCP, des moyens d'identification MID, des moyens de vérification d'alerte MVA, des moyens d'alcrte MA et des moyens de configuration MCONF au moyen de signaux d'activation ENM, ENC, ENI, ENV, ENA et ENO respectivement.

Un tel dispositif comporte des moyens de mesure MMNC d'une valeur courante NC d'un paramètre représentatif d'un niveau de charge d'une batterie BAT. Ces moyens de mesure MMNC pourront par exemple être aptes à mesurer une tension délivrée par la batterie BAT, tension dont une valeur instantanée constituera la valeur courante NC. Cette valeur courante NC est comparée à l'aide de moyens de comparaison MCP à une valeur seuil Th prédéfinie. Ces moyens de comparaison MCP pourront par exemple être constitués par un amplificateur opérationnel destiné à délivrer un signal de comparaison RCP dont la valeur sera représentative du résultat de la comparaison. Ce signal RCP est reçu par des moyens d'identification MID aptes à déterminer le mode de fonctionnement actif du terminal quelle que soit la valeur du signal de comparaison RCP.

Si, à l'issue de la détermination précédente, les moyens d'identification montrent que le mode de fonctionnement actif est un mode de fonctionnement économique et qu'en outre la valeur courante NC est supérieure à la valeur seuil Th, des moyens de configuration MCONF sont prévus pour configurer le terminal dans le mode de fonctionnement nominal. Ces moyens de configuration MCONF communiquent avec une base de registres BR prévue pour stocker les données nécessaires à la configuration des modes de fonctionnement et notamment des modes de fonctionnement économique apportés par des moyens de chargement de données de configuration MC.

Si la valeur courante NC est supérieure à la valeur seuil Th, mais que le mode de fonctionnement actif n'est pas un mode de fonctionnement économique, alors aucun autre moyen n'est activé. De même, si la valeur courante NC est inférieure à la valeur seuil Th et que le mode de fonctionnement actif est un mode de fonctionnement économique, alors aucun autre moyen n'est activé.

En revanche, si la valeur courante NC est inférieure à la valeur seuil Th et que le mode de fonctionnement actif n'est pas un mode de fonctionnement économique, alors des moyens de vérification d'alerte MVA sont activés. Si l'alerte a déjà été donnée, aucun autre moyen n'est activé par la suite, sinon les moyens de vérification MVA activent des moyens d'alerte MA. Ces moyens d'alerte MA sont prévus pour avertir l'utilisateur du terminal que la batterie BAT dispose d'une faible valeur courante NC de niveau de charge et lui proposent ou suggèrent une configuration en un mode de fonctionnement économique.

Si l'utilisateur décide la configuration du terminal en un mode de fonctionnement économique, les moyens d'alerte activent les moyens de configuration MCONF qui configurent le terminal en un mode de fonctionnement économique prédéfini. Si l'utilisateur choisit de rester dans le mode de fonctionnement actif, aucun moyen n'est activé en conséquence.

## Revendications

1. Procédé de transmission de données au moyen d'au moins un terminal mobile, ledit procédé impliquant une surveillance d'un niveau de charge d'une batterie d'un terminal mobile et incluant :
- une étape de mesure d'une valeur courante d'un paramètre représentatif dudit niveau de charge ;
- une étape de comparaison de la valeur courante ainsi mesurée avec une valeur seuil prédéterminée ; et
- une étape de configuration du terminal en un mode de fonctionnement économique préalablement défini si la valeur courante est inférieure ou égale à la valeur seuil et si suite à l'exécution d'une étape d'alerte, un utilisateur dudit terminal mobile à donné son accord pour que cette étape de configuration soit exécutée.

2. Procédé de transmission de données selon la revendication 1, incluant une étape de chargement préalable de chargement de données de configuration définissant le mode de fonctionnement économique.

3. Procédé de transmission de données selon la revendication 1 ou 2, incluant en outre une étape d'identification d'un mode de fonctionnement actif dans lequel se trouve le terminal, destinée à être exécutée préalablement à l'étape de configuration.

4. Procédé de transmission de données selon l'une des revendications précédentes, selon lequel ladite étape d'alerte consiste en au moins un stimulus d'alerte émis à l'attention de l'utilisateur afin de l'informer d'un faible niveau de charge de la batterie et d'un possible changement de mode de fonctionnement, ladite étape d'alerte étant destinée à être exécutée préalablement à l'étape de configuration.

5. Procédé de transmission de données selon la revendication 4, incluant en outre une étape de vérification d'alerte destinée à apporter confirmation de l'émission effective d'au moins un stimulus d'alerte, ladite étape de vérification étant destinée à être exécutée préalablement à l'étape de configuration.

6. Dispositif de transmission de données d'un niveau de charge d'une batterie d'un terminal mobile, incluant :
- des moyens de mesure d'une valeur courante d'un paramètre représentatif dudit niveau de charge ;
- des moyens de comparaison de la valeur courante ainsi mesurée avec une valeur seuil prédéterminée ; et
- des moyens de configuration prévus pour configurer ledit terminal en un mode de fonctionnement économique préalablement défini si la valeur courante est inférieure ou égale à la valeur seuil et si suite à la mise en oeuvre de moyens d'alerte, un utilisateur dudit terminal mobile à donné son accord pour que ces moyens de configuration soient mis en oeuvre.

7. Dispositif de transmission de données selon la revendication 6, incluant des moyens de chargement préalable de données de configuration définissant le mode de fonctionnement économique.

8. Dispositif de transmission de données selon la revendication 6 ou 7, incluant en outre des moyens d'identification du mode de fonctionnement actif dans lequel se trouve le terminal et destinés à être activés préalablement à la mise en oeuvre des moyens de configuration.

9. Dispositif de transmission de données selon l'une des revendications 6 à 8, selon lequel les moyens d'alerte comportent des moyens pour émettre au moins un stimulus d'alerte à l'attention de l'utilisateur afin de l'informer d'un faible niveau de charge de la batterie et d'un possible changement de mode de fonctionnement, les moyens d'alerte étant destinés à être activés préalablement à la mise en oeuvre des moyens de configuration.

10. Dispositif de transmission de données selon la revendication 9, incluant en outre des moyens de vérification d'alerte destinés à apporter confirmation de l'émission effective d'au moins un stimulus d'alerte, lesdits moyens de vérification étant destinés à être activés préalablement à la mise en oeuvre des moyens de configuration.
